# EUROPEAN PATENT SPECIFICATION

(11) **EP 4 420 489 B1**
(45) Date of publication and mention of the grant of the patent: **07.10.2026**
(21) Application number: 23781942.0
(22) Date of filing: 24.01.2023
(51) Int. Cl.: H01J 65/04, H01S 3/00, H01S 3/02, H01S 3/094, H01S 3/102, H01S 3/113, H01S 5/40, G02B 27/14, H01S 3/06, H01S 3/0941, H01S 5/02208, H01S 3/16, H01S 3/23, H01S 5/02325

(54) **ALL-OPTICAL LASER-DRIVEN LIGHT SOURCE WITH ELECTRODELESS IGNITION AND CORRESPONDING OPERATING PROCEDURE**
DURCH REIN OPTISCHEN LASER GESTEUERTE LICHTQUELLE MIT ELEKTRODENLOSER ZÜNDUNG UND ENTSPRECHENDES BETRIEBSVERFAHREN
SOURCE LUMINEUSE TOUT OPTIQUE COMMANDÉE PAR LASER À ALLUMAGE SANS ÉLECTRODE ET PROCÉDURE DE FONCTIONNEMENT CORRESPONDANTE

(30) Priority: 29.03.2022 US 202217707109
(43) Date of publication of application: 28.08.2024
(73) Proprietor: Hamamatsu Photonics K.K., Hamamatsu-shi, Shizuoka 435-8558 (JP); Energetiq Technology, Inc., Wilmington, MA 01887 (US)
(72) Inventor: PARTLOW, Matthew, Townsend, Washington 98368 (US); SMITH, Donald, Newton, Massachusetts 02458 (US); BESEN, Matthew, Andover, Massachusetts 01810 (US); ASAI, Akinori, Hamamatsu-shi, Shizuoka 435-8558 (JP)
(74) Representative: Grünecker Patent- und Rechtsanwälte PartG mbB
(86) International application number: PCT/US2023/061200
(87) International publication number: WO 2023/192696

(56) References cited:
- WO-A1-2018/136683
- JP-A- 2018 006 394
- KR-A- 20160 071 231
- US-A1- 2005 276 285
- US-A1- 2011 026 547
- US-B1- 10 770 282
- US-B1- 7 705 331

## Description

The section headings used herein are for organizational purposes only and should not be construed as limiting the subject matter described in the present application in any way.

### Introduction

Numerous commercial and academic applications have need for high brightness light over a broad wavelength range. For example, laser-driven light sources are available that provide high brightness over spectral ranges from the extreme UV through visible and into the infrared regions of the spectrum with high reliability and long lifetimes. Various examples of such high-brightness light sources are produced by Energetiq, a Hamamatsu Company, located in Wilmington, MA. Reference is also made to JP 2018 006394 A.

There is growing demand for high-brightness light sources for applications including, for example, semiconductor metrology, sensor calibration and testing, creating shaped light, surface metrology, spectroscopy and other optical measurement applications in diverse fields including biology, chemistry, climate, and physics. As such, advances are needed in high-brightness light sources that can improve, for example, size, cost, complexity, reliability, stability and efficiency of these important types of broadband light sources.

### Brief Description of the Drawings

The present teaching, in accordance with preferred and exemplary embodiments, together with further advantages thereof, is more particularly described in the following detailed description, taken in conjunction with the accompanying drawings. The skilled person in the art will understand that the drawings, described below, are for illustration purposes only. The drawings are not necessarily to scale; emphasis instead generally being placed upon illustrating principles of the teaching. The drawings are not intended to limit the scope of the Applicant's teaching in any way.
FIG. 1 illustrates a schematic of an embodiment of a laser-driven light source comprising electrodeless ignition according to the present teaching.
FIG. 2A illustrates an image of a gas-filled bulb of an electrodeless laser-driven light source according to the present teaching that shows the emission with only pulse laser excitation.
FIG. 2B illustrates an image of a gas-filled bulb of an electrodeless laser-driven light source according to the present teaching that shows the emission with only CW laser excitation.
FIG. 3 illustrates steps of a method to ignite a plasma in an electrodeless all-optical laser-driven light source according to the present teaching.
FIG. 4A illustrates an embodiment of a Q-switched crystal of the present teaching that includes a gain region and a saturable gain/loss region.
FIG. 4B illustrates a passively Q-switched laser rod suitable for an electrodeless laser-driven light source according to the present teaching.
FIG. 5 illustrates a graph of the pulse energy and pump current threshold for a pump laser that creates a laser pulse sufficient to result in gas breakdown as a function of the pulse length of the quasi-CW pump pulse suitable for an electrodeless laser-driven light source according to the present teaching.
FIG. 6 illustrates a gas-filled bulb system with a focusing lens assembly suitable for use in an electrodeless laser-driven light source according to the present teaching.
FIG. 7 illustrates an electrodeless laser-driven light source where a pump light is co-linear with CW laser light and a pulsed laser light is projected into the gas-filled bulb in one plane and the CW laser light is projected into the gas-filled bulb in a second plane according to the present teaching.
FIG. 8 illustrates an embodiment of an electrodeless laser-driven light source where the CW laser light and the pump light are combined in a fiber combiner and the pump light, the CW laser light, and the pulse light are projected into a gas-filled bulb along a same plane according to the present teaching.
FIG. 9 illustrates a detail-view of the excitation region in an embodiment of an electrodeless laser-driven light source with co-linear laser excitation according to the present teaching.
FIG. 10 illustrates an embodiment of a packaged electrodeless laser-driven light source with co-linear laser excitation according to the present teaching.

### Description of Various Embodiments

The present teaching will now be described in more detail with reference to exemplary embodiments thereof as shown in the accompanying drawings. While the present teaching is described in conjunction with various embodiments and examples, it is not intended that the present teaching be limited to such embodiments. On the contrary, the present teaching encompasses various alternatives, modifications and equivalents, as will be appreciated by those of skill in the art. Those of ordinary skill in the art having access to the teaching herein will recognize additional implementations, modifications, and embodiments, as well as other fields of use, which are within the scope of the present disclosure as described herein.

Reference in the specification to "one embodiment" or "an embodiment" means that a particular feature, structure, or characteristic described in connection with the embodiment is included in at least one embodiment of the teaching. The appearances of the phrase "in one embodiment" in various places in the specification are not necessarily all referring to the same embodiment.

It should be understood that the individual steps of the method of the present teaching can be performed in any order and/or simultaneously as long as the teaching remains operable. Furthermore, it should be understood that the apparatus and method of the present teaching can include any number or all of the described embodiments as long as the teaching remains operable.

Laser driven light sources use a CW laser to directly heat a gas plasma to the high temperature needed to produce broadband optical light. High-brightness laser driven light sources have a significant advantage compared to light sources that use high-voltage electrodes to sustain a plasma. Laser driven sources depend on optical-discharge plasma as opposed to electric discharge plasma used in, for example, arc-lamp devices. In electric discharge lamps, electrode materials can evaporate, and change the properties of the discharge over the life of the lamp. This reduces lamp lifetime. Also, electrode-based systems lead to thermal, mechanical and electrical stress of the light source. Known laser driven light sources do not rely on electrodes to sustain the plasma, however they still utilize electrodes for plasma ignition.

Known light sources that rely on electrodes can have serious limitations. For example, electrode-based light sources can have limits on the lamp head size and restrictions on how bulb can be mounted. Electrode-based light sources must be designed to avoid parasitic arcs, and the lamp head needs be configured with sufficient volume for electrodes and for ignition circuit. Electrode-based light sources have limitations on the cold fill pressure of the bulb because, for example, the glass-to-metal seal of electrodes can limit the maximum fill pressure. Also, the size of the bulb can be larger in electrode-based light sources, which can affect bulb fill pressure. Electrode-based light sources also have limited bulb shapes that can be accommodated. This is because, for example, electrode-based light sources require positioning, securing, and connecting electrodes. These design constraints can result in producing noise in the light source.

Thus, providing a laser driven light source with electrodeless ignition can lead to improved reliability, performance, reduced cost and complexity in addition to other benefits. Igniting a plasma with optical illumination requires careful design and control of the light source and associated light delivery mechanisms used to ignite the plasma. One feature of the present teaching is providing a laser-driven light source with electrodeless ignition. In these sources, the plasma is ignited by optical illumination, and not by electrical energy provided by an electrode as in known laser driven high-brightness light sources.

There are numerous features and benefits of electrodeless laser driven light sources. Electrodeless light sources can be implemented using a smaller bulb with higher maximum fill pressures than prior art light sources. A higher fill pressure can result in higher brightness, especially in certain laser power regimes. Electrodeless light sources have no contamination from electrode material. In addition, there are fewer lamp shape geometry limitations. Generally smaller lamp heads can be used for the same characteristics. Also, there are no high-voltage active electrical components to power, thereby reducing the need for an associated power supplies, control electronics and electrical connection, which significantly reduces the number of required components. However, some embodiments of electrodeless laser drive light source can be implemented in the existing lamp package of laser-driven light sources that do have electrode ignition. This is at least, in part, because the electrodeless device is generally less complex and smaller than electrode-based laser driven light sources. For example, an electrodeless laser-driven light sources is described in U.S. Patent Application Serial Number 17/328,433, entitled "Laser-Driven Light Source with Electrodeless Ignition", which is assigned to the present assignee and which is also incorporated herein by reference.

One feature of the present teaching is that it can provide an electrodeless laser-driven light source without the need to electronically control a separate igniting optical pulse. Rather, the optical ignition pulses are generated all-optically within the source components. Such an approach has several advantages over electrodeless laser-driven light source where the pulse source is controlled electrically. For example, an even smaller bulb can be used. Also, the number of electronic connections to the source package can be reduced. Also, no specialized power supplies or laser drive electronics are needed to form an electronically-driven and controlled pulse source.

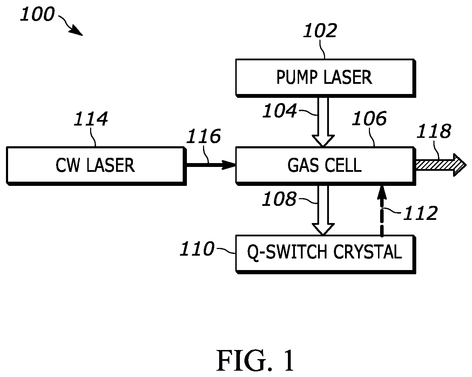

FIG. 1 illustrates a schematic of an embodiment of a laser-driven light source 100 comprising electrodeless ignition according to the present teaching. A pump laser 102 supplies optical pump light 104 to a gas cell 106. The pump light passes through the cell and emerges as through pump light 108 that is provided to a Q-switch crystal 110. The through pump light 108 emerging from the gas cell 106 has the appropriate energy to cause the Q-switch crystal 110 to generate optical pulsed light 112 that is provided back to the gas cell 106. Energy from the optical pulse light 112 is provided to a plasma breakdown region in the gas cell 106 and ignites the plasma. In some embodiments, the gas cell 106 is a gas-filled bulb. In some embodiments, the gas cell 106 is a gas chamber that includes at least one window that passes the wavelengths of the pump light 104, the optical pulsed light 112, CW light 114 and high-brightness CW plasma light 118.

A CW laser 114 generates the CW laser light 116. The CW laser light 116 is provided to the gas cell 108 as a sustaining light to the plasma breakdown region in the gas cell 108. The region illuminated by the pulse laser light 112 in the gas cell 106 may be referred to as a pulse illumination region, and has a well-defined position and shape based on the optical projection elements (not shown) that are used to direct the pulse light 112 from the Q-switch crystal 110 and the CW laser light 116 to the cell 106. These projection elements include various focusing and/or directing elements in various different embodiments. Energy from the optical pulsed light 112 provided to the plasma breakdown region in the cell 106 ignites the plasma. The region illuminated by the CW sustaining light may be referred to as a CW sustaining illumination region, and has a well-defined position and shape based on the projection elements not shown used to direct the optical light from the CW laser 114. These projection elements include various focusing and/or directing elements in various different embodiments. Energy from the CW laser light 114 provided to the plasma breakdown region sustains the plasma. The plasma breakdown region produces high-brightness CW plasma light 118.

The optical pulsed light 112 has the high-peak-power needed to ignite a plasma in the gas cell 106. However, to generate sustained CW plasma light 118, the optical pulsed light 112 must not exceed a certain energy/power threshold, which can occur if optical pulses are present in the plasma after a predetermined delay after the plasma light 118 reaches a predetermined threshold. Too much optical pulse light 112 energy delivered to the gas cell 106 can extinguish the plasma. To prevent the optical pulse light 112 from extinguishing the plasma, a mechanism is needed to extinguish the pulsed light 112 after the generation of sustained CW plasma light. This can be implemented in the all-optical laser driven light source 100 by exploiting pump laser light reduction in the gas cell 106 that occurs when the plasma ignites. When the plasma ignites, the pump light that passes through the cell and emerges as through pump light 108 that is provided to a Q-switch crystal 110 is much reduced in power compared to the pump light 104 that emerges from the pump laser 102. Also, the pump light that passes through the cell 106 and emerges as through pump light 108 when the plasma is ignited is much reduced in power compared to the pump light that passes through the cell 106 and emerges as through pump light 108 when the plasma is not ignited. This extinguished through pump light 108 in turn extinguishes the pulse laser light 112. By extinguishing the pulsed light 112 before a subsequent pulse extinguishes the CW plasma, the plasma light can be sustained by application of only the CW sustaining light 116 from the CW laser 114.

Because the pulsed light 112 is stopped when the CW plasma ignites, there is no need for a sensor and/or an electronic shutter and/or other electronic shut off to actively extinguish the pulse light 112 after breakdown. If the plasma extinguishes for some unexpected reason, it will automatically start to try pulse ignition again, since the plasma will not be present to absorb the pump light. In other words, the plasma will self-re-ignite. This leads to a simple, compact, and high reliability electrodeless source. There is no need for active monitoring to control the pulsed light.

One feature of embodiments of the all-optical electrodeless source of the present teaching, is that the position of the pulse illumination region and the CW sustaining illumination region can be adjusted to provide a desired performance of the plasma light. The relative position of the pulse illumination region and the CW sustaining illumination region impacts the threshold of the energy/power beyond which a CW sustaining plasma is exceeded. In some embodiments, the two regions are distinct and do not overlap. In some embodiments, the two regions overlap to a small degree.

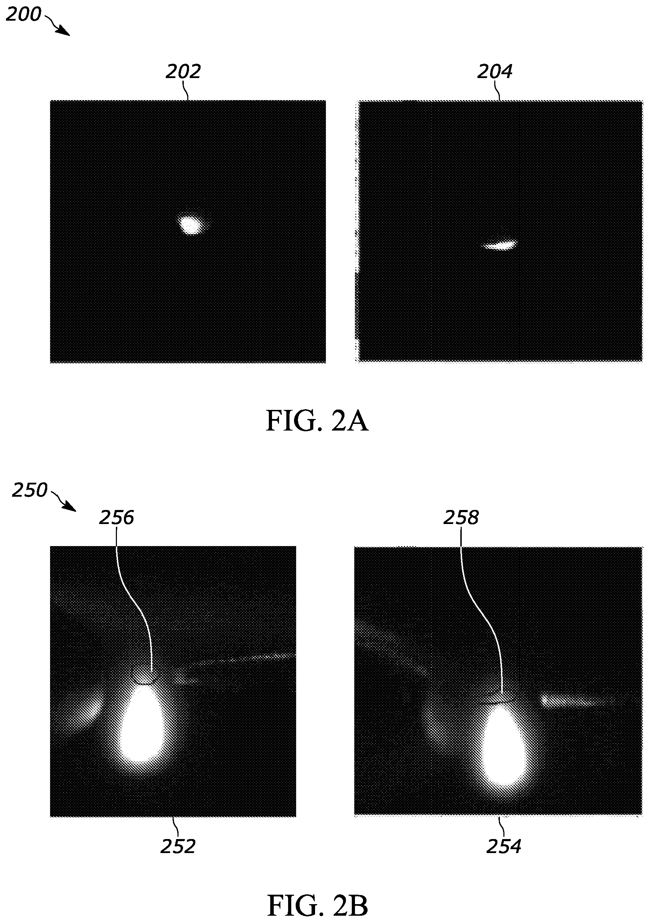

FIG. 2A illustrates images 200 of a gas-filled bulb in an embodiment of an electrodeless laser-driven light source according to the present teaching that shows the emission with only pulse laser excitation. Both images 202, 204 are shown from a side-view, but they are offset in angle to illustrate the three-dimensional positioning of the locations of the pulsed illumination region and the focus of the CW laser. The extent and position of the pulsed illumination region is visible in these images 202, 204. Note that the position of pulse breakdown depends on the pulse energy. As the energy increases, breakdown location moves toward pulsed laser. Three-dimensional alignment of the pulse laser breakdown plasma relative to the pulsed light and relative to the focus of the CW laser allows the method to work with lower CW laser power and/or lower pulse energy.

FIG. 2B illustrates images 250 of the gas-filled bulb shown in FIG. 2A that shows the emission with only CW laser excitation. Both images 252, 254 are shown from a side-view, but they are offset in angle to illustrate the three-dimensional positioning of the locations of the pulsed illumination region and the focus of the CW laser. The extent and position of the pulsed illumination region is visible in these images 252, 254. Outlines 256, 258 of the pulse illumination regions from the images 202, 204 of FIG. 2A are also illustrated. In this embodiment, the relative positions and shapes of the pulsed illumination region and the CW sustaining illumination region are such that the two regions are distinct and do not overlap. The pulse illumination region is smaller as the light is more tightly focused, resulting in a high density of pulsed energy delivered to the plasma by the illumination.

The images of FIGS. 2A-B were collected during experiments to determine operating parameters for pulses that provide plasma ignition. Some details of the experimental conditions are described below. For example, with a 2-kHz pulse rate and 1-ns-duration pulse, stable plasma ignition can be realized in a Xenon gas-filled bulb over a range of energies from 135 to 225 micro Joule. The pulse light had a 1064 nm wavelength. For this particular example of an experimental configuration, the threshold energy to breakdown light to achieve a stable CW plasma was 135 micro Joule. Furthermore, at 210 micro Joules, the plasma ignites and can eventually be stable, but there can be ignition and extinguishing of CW plasma before the stable operation. It is also possible to realize ignition at 225 micro Joules and higher. The relative position of the pulsed light illumination and the CW light illumination is critical. Adjusting the bulb and CW laser alignment along the optical axis of the pulsed laser improves or 'turns off' ignition. In this experiment, after the CW plasma was lit, the CW laser power could be lowered to 8-10 Watts while still sustaining the CW laser power. At any value of CW laser power above 15.5 Watts, there was reliable transition from pulse to CW. There was no upper limit on CW laser power experienced. As understood by those skilled in the art, the beam quality affects the energy delivered to the gas for a given laser power.

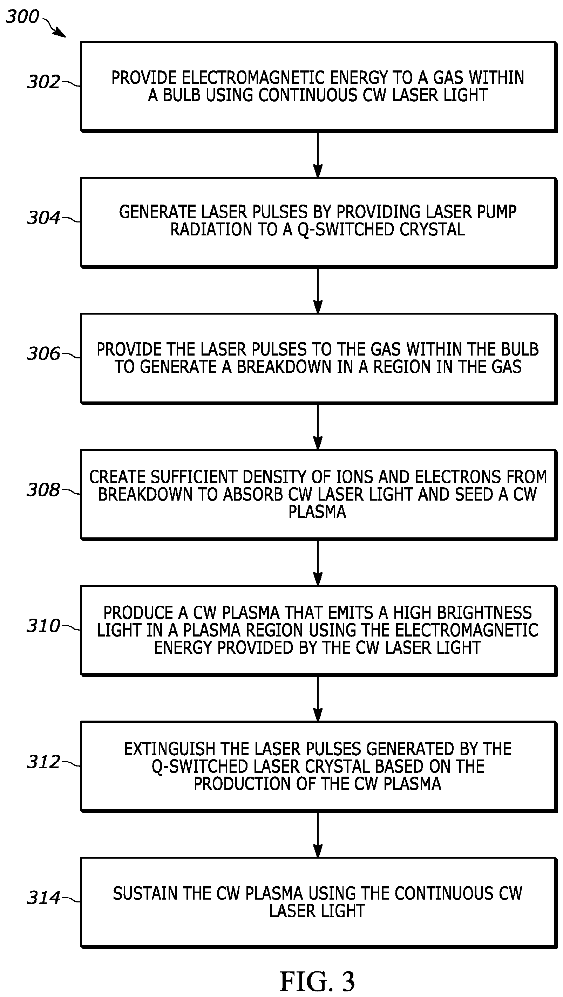

One feature of the all-optical electrodeless laser-driven light source of the present teaching is that the pulse laser light can be extinguished by an absorptive process in the gas cell, rather than relying on external electronic feedback. FIG. 3 illustrates steps of a method to ignite a plasma in an electrodeless all-optical laser-driven light source according to the present teaching. In a first step 302, electromagnetic energy is provided to a gas within a bulb using continuous wave CW laser light (e.g. light 116 from laser 104 into gas cell 106 of FIG. 1). In a second step 304, laser pump radiation is provided to a Q-switched crystal (e.g. light 108 from laser 112 into crystal 116 of FIG. 1). The laser pump radiation causes the Q-switched crystal to generate pulsed light with a particular pulse duration and pulse repetition rate that is dependent upon the power of the laser pump radiation input to the crystal. In a third step 306, the generated pulsed light is provided to a gas (e.g. light 112 provided to cell 106 of FIG. 1). In some embodiments, the gas is contained in a pressurized bulb. In some embodiments, the gas is Xenon gas. The provided pulsed laser light generates a breakdown in a region of the gas, the break-down region. In a fourth step 308, a sufficient density of ions and electrons in the break-down region are generated to absorb the provided CW laser light to seed a CW plasma. In a fifth step 310, the electromagnetic energy provided by the CW laser light produces a CW plasma that emits a high brightness light in a plasma region. In a sixth step 312, the production of the CW plasma extinguishes the pulsed light generated by the Q-switched crystal. In some embodiments the extinguishing is a result of absorption of the pump light passing through the gas with ignited plasma before impinging on the Q-switched crystal. In a seventh step, after the pulsed laser light is extinguished the high brightness light is sustained by sustaining the plasma in the bulb or other container using the CW laser light. We note that in some embodiments the CW continuous light is nominally a continuous light source that is produced by pulsed laser operation at a high pulse rate. In some configurations, the laser that sustains the CW plasma can also be the same laser that pumps the non-linear crystal.

Various embodiments of the laser-driven high brightness sources with electrodeless ignition of the present teaching use different parameters of the light provided to the gas. For example, the repetition rate of Q-switched laser pulses can be controlled. The pulse energy of the pulse light that is provided to the gas can be controlled. The duration of the Q-switch laser pulses can also be controlled. In addition, the power of the CW laser light is also controlled. In some embodiments, a pulse repetition rate of the pulsed laser light is in a range of 1 kHz to 20 kHz.

Experimental and/or theoretical evaluations have determined that quality CW plasma can be provided, for example, when the Q-switch laser crystal is configured so that a pulse repetition rate of the pulsed laser light is less than or equal to 1 kHz. Continuous wave plasma can be produced when the Q-switched laser crystal is configured so that a pulse energy of the pulsed laser light is in a range of 50 micro Joules to 500 micro Joules.

Continuous wave plasma is produced under a variety of pulse energy, pulse duration, and CW power conditions depending on the particular configuration. For example, continuous wave plasma is produced when the Q-switch laser crystal is configured so that a pulse energy of the pulsed laser light is in a range of 500 micro Joules to 5 millijoules. In addition, continuous wave plasma can be produced when the Q-switch laser crystal is configured so that a pulse duration of the pulsed laser light is in a range of 0.1 ns to 10 ns. Continuous wave plasma can also be produced when the CW laser source is configured so that a power of the CW sustaining light is in a range of 5W to 50 W. Also, continuous wave plasma can be produced when the CW laser source is configured so that a power of the CW sustaining light is in a range of 5W to 1500 W. The ranges described above are just examples of operating ranges, and not intended to limit the present teaching in any way.

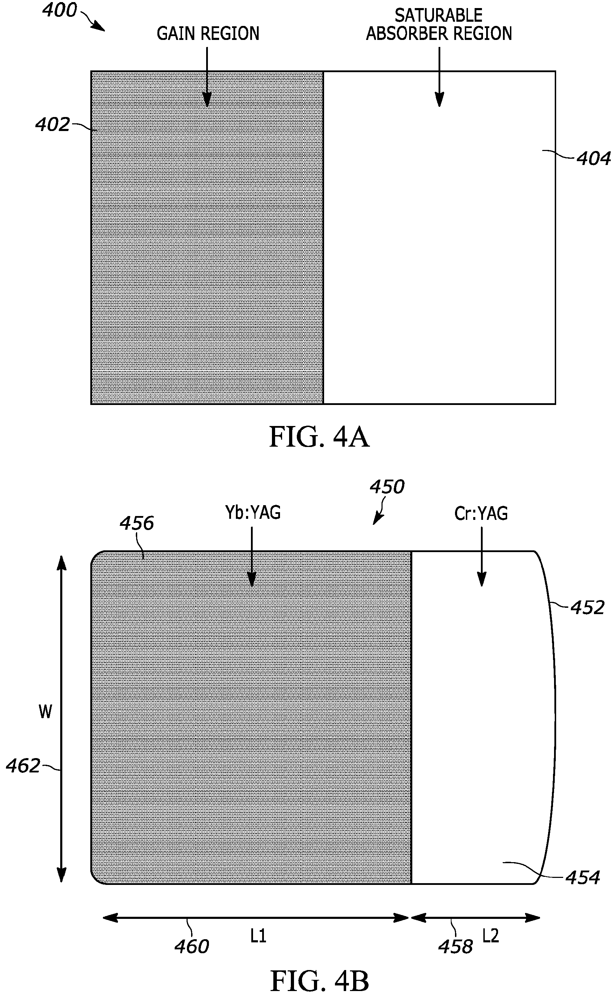

One feature of the present teaching is that it can use different known Q-switch crystals. The wavelength of the pulsed light should be appropriate to cause a breakdown of the gas specie(s) in the bulb. FIG. 4A illustrates an embodiment of a Q-switched crystal 400 of the present teaching that includes a gain region 402 and a saturable gain/loss region 404. As understood by those skilled in the art, different host materials and dopants can be used to provide a suitable gain region 402 and a saturable absorber region 404. For example, the crystal 400 can have a host material that can be a glass host, an yttrium aluminum garnet host, or a spinel host. For example, the crystal 400 can have a dopant in one or both of the gain region 402 and saturable absorber region 404 that can be an ytterbium dopant, a chromium dopant, a cobalt dopant or a vanadium dopant. The Q-switch crystal can also include a narrow-band filter that can be used, for example, to reflect at least some of the plasma light and/or block wavelengths in the Xenon spectrum. This coating, for example, can be a protective coating, a reflective coating, and/or an anti-reflection coating.

FIG. 4B illustrates a passively Q-switched laser rod 450 suitable for an electrodeless laser-driven light source according to the present teaching. The yttrium aluminum garnet based (YAG-based) passively Q-switched laser rod 450 has a curved face 452. The saturable absorber region 454 is a chromium dopant in an yttrium aluminum garnet host. The gain region 456 is an ytterbium dopant in an yttrium aluminum garnet host. The dopant and host contribute to setting the wavelength of the pulsed light as well as the rise and fall time of the pulses. A saturable absorber region length 458, L2, a gain region length 460, L1, and a crystal width 462, W, are chosen to provide desired output pulse parameters, including, for example, pulse repetition rate, pulse duration, pulse energy.

Q-switch crystals are a proven technology. For example, Q-switch crystals are used in known passively Q-switched microchip lasers. As one particular example, a microchip laser using a crystal with a saturable absorber region length 458, L2=1.36 mm, a gain region length 460, L1= 3 mm, and a crystal width 462, W=3 mm, provided 1.6 ns pulses having 74 microJoules of energy at 14-kH repetition rate and was realized from a 10-W pump power at 970 nm wavelength pump laser. With increasing pump power, the mean output power, and generated pulse repetition rate can be increased to 1 W and 13.6 kHz, respectively, for a pumping power 9.3 W. A maximum output power can be reached without observable thermal roll-over. An average pulse width of 1.58 ± 0.04 ns can also be realized. In practice, a pulse energy and peak power value of 73.8 ± 0.7 µJ, and 46.0 ± 0.8kW, respectively, was realized. One feature of the present teaching is that electrodeless ignition can be realized with pulsed light parameters that can be realized by these highly available, compact, reliable sources of optical pulses provided by Q-switch crystals 400, 450 that are pumped with optical pump light.

Pumping efficiency and pulse output depend on various properties of the crystal 400, 450 including for the gain crystal 402, 456, the doping element (e.g. YB or Nd), the doping percentage, and the diameter and length. For the saturable absorber crystal 404, 452, the doping element (e.g. Cr or V), the doping percentage, initial absorption percent, diameter and/or length. In some embodiments, reflection and/or transmission coatings for pump wavelength and pulsed light wavelength are provided on one or more ends of the crystal 400, 450. For example, a Yb:YAG-Cr:YAG bonded crystal can include a coating on the Yb:YAG end that is high transmission for 940 nm, and high reflection for 1030 nm. And, on the Cr:YAG end, the crystal can have a coating that is only partially reflective at 1030 nm (i.e. output coupler). While many Q-switched lasers have pump configurations that have the saturable absorber and output coupler on the opposite end from the incoming pump laser, pulsed Q-switch crystals for electrodeless ignition can have the output coupler at the pump input end, rather than the saturable absorber end.

Some embodiments of the crystal 400, 450, can have undoped end sections around the Yb:YAG or Cr:YAG, which can be referred to as a non-absorbing mirror. Such a configuration avoids thermal overload and facet failure. In the gain region 402, 456, a gain medium of Nd:YAG is common and relatively low cost. A Nd:YAG gain region 402, 456 is pumped at 808 nm, and emits light at 1064 nm. A gain region 402, 456 of Yb:YAG is less common and more expensive. This material is pumped at 940 or 970 nm wavelength and emits light at 1030 nm. These Yb:YAG crystals are most commonly coated to accommodate for 940 nm pumping. Crystals coated for 940 nm may not work well at 970 nm (e.g. coating at 940 nm only 60% transmissive at 970nm.). In addition, 940 nm wavelength light is generally easier than 970 nm light to separate from 1030 nm. It is also possible for Yb doped glass to be pumped at 975 nm. This pump wavelength is the same as used in known laser driven light source laser wavelengths.

Some important features in the design of a Q-switch crystal for producing pulsed light for electrodeless ignition according to the present teaching include, for example, choice of laser wavelength, the order of arrangement of coatings, gain section, saturable absorber section, and the direction of the pump pulse input and output. Other important features include the combining/separation of the pump and plasma beams and accommodation of a need to protect the CW laser from the pulses produced by the Q-switch crystal. Referring back to FIG. 1 different embodiments of the light source 100 can have different configurations for the positions of the pump laser 102, Q-switch crystal 116 and CW laser 114 that impact these design choices. In addition, because of the high pulse energies, the mounting of the crystal 116 and associated thermal management are important considerations.

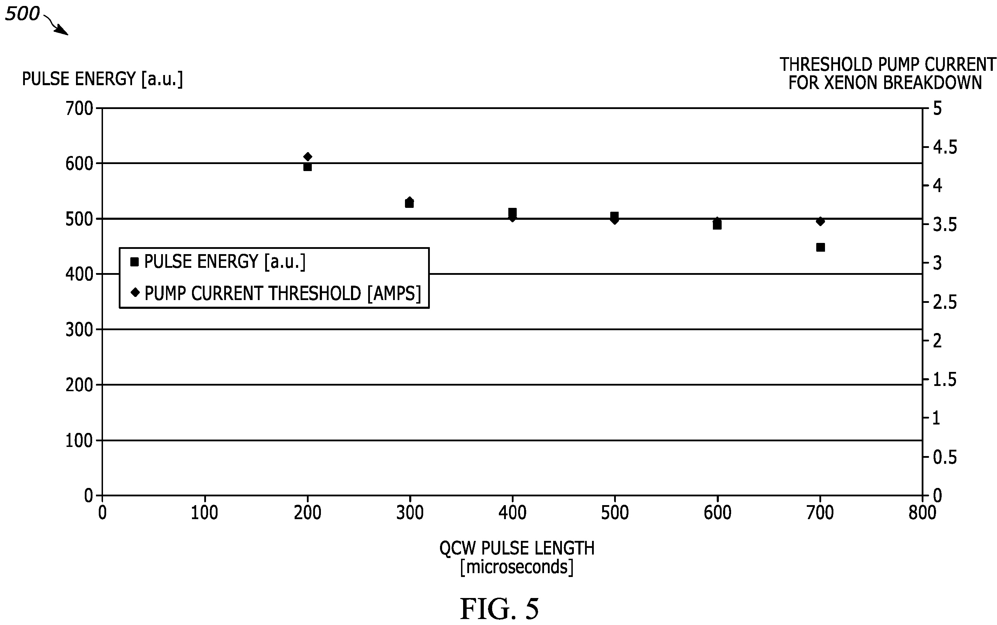

FIG. 5 illustrates a graph 500 of the pulse energy and pump current threshold for a pump laser that creates a laser pulse sufficient to result in gas breakdown as a function of the pulse length of the quasi-CW (QCW) pump pulse used in an embodiment of an electrodeless laser-driven light source according to the present teaching. That is, the pulse length is a width of a pulse that is repetitive (e.g. width of pulse in a square wave signal) that is used to generate a quasi-CW pump light signal. The graph 500 represents measurements on a bulb containing xenon gas. The graph 500 illustrates an example operating point, and shows that operation can occur over a range of pulse durations. The threshold levels out above pulse lengths of ~500 microseconds. Note that various embodiments of the light source of the present teaching can operate with parameters that are different from those illustrated in this example data. Some examples of operational parameters of pulsed ignition and transition handoff for a 22 atmosphere pressure cold bulb fill with xenon gas are as follows: (1) a CW transition handoff can be realized with CW laser power as low as 14 W at a 980 nm wavelength; (2) a CW transition handoff can be realized with CW laser light center wavelength as low as 972 nm; (3) a nearly instantaneous CW transition handoff can be realized with CW laser light center wavelength as low as 975 nm; and 4) a CW transition handoff can be realized with CW laser power as high as 50 Watts. When the content of laser spectrum at 980 nm goes to zero, a transition handoff may take from seconds to one or two minutes. When the CW laser power is at 20 Watts, the vary center wavelength is between 1-2 nm away from a 980 nm center wavelength for successful transition handoff. With a 30 atmosphere cold-fill bulb, it is possible to achieve a CW transition handoff at 30 Watts and 976 nm center wavelength from the CW laser. In general, ignition is more robust with a higher pressure bulb than a lower pressure bulb. For examples, a bulb with a pressures over 30 atm would in general have a more robust ignition than a bulb with a pressure of about 22 atm.

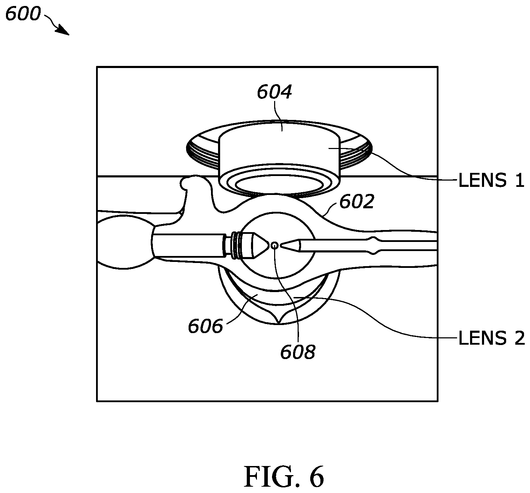

FIG. 6 illustrates a gas-filled bulb system 600 with a focusing lens assembly 604, 606 suitable for use in an electrodeless laser-driven light source according to the present teaching. The plasma region 608 is shown. The focusing lens assemblies 604, 606 are configured at planes that are oriented at 90-degrees from one another. One assembly 604 directs the pulse light to the plasma region 608 in the bulb 602, and the other assembly 606 directs the CW sustaining light to the plasma region 608 in the bulb 602. As described herein, the shapes of the pulsed illumination and the CW sustaining illumination in the plasma region 608 can be the same or different. The positions of the pulsed illumination and the CW sustaining illumination in the plasma region 608 can be overlapped or can be distinct. In some embodiments, the bulb 602 is filled with Xenon gas. In some embodiments, the bulb 602 is formed in a spherical shape. Also, in some embodiments, a pressure in the bulb 602 filled with gas can be a pressure in a range of 20 atm to 50 atm. Referring back to FIG. 5, there illustrates a graph of the pulse energy and pump current threshold for a pump laser that creates a laser pulse sufficient to result in gas breakdown as a function of the pulse length for a passively Q-switched laser crystal suitable for an electrodeless laser-driven light source according to the present teaching.

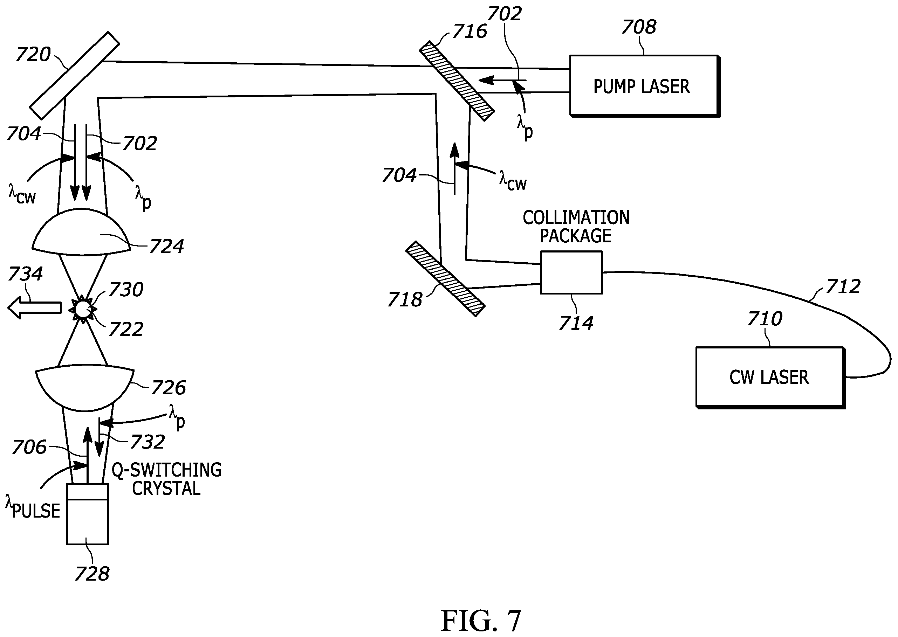

FIG. 7 illustrates an electrodeless laser-driven light source 700 where a pump light 702 is co-linear with CW laser light 704 and a pulsed laser light 706 is projected into the gas-filled bulb (not shown) in one plane and the CW laser light 704 is projected into the gas-filled bulb in a second plane according to the present teaching. A pump laser 708 generates pump light 702. In some embodiments, the pump light 702 is continuous light with a particular average power. A CW laser 710 generates CW light 704. The CW laser 710 can be a fiber laser and the light 704 is delivered via and optical fiber 712 into free space using a collimation package 714. The pump light 702 has a wavelength, λp, the CW light 704 has a wavelength, λCW, and the pulse laser light 706 has a wavelength λpulse. A dichroic mirror 716 is used to combine the output light from the CW laser 710 and the pump laser 708 into co-linear propagation. An optional directing element 718 can be used to direct the light from the collimation package 714 to the dichroic mirror 716. The mirror 716 in some embodiments is a long-pass transmissive component with high transmission below around 900 nm and has high reflectance above about 900 nm. An optional directing mirror 720 can be used to project the colinear propagating pump light 702 and CW laser light 704 to a focusing element 724 and to a plasma sustaining region 722. A second focusing element 726 focuses pulse light 706 from a Q-switched crystal 728 into a breakdown region 730. The focusing element 726 also collimates and/or refocuses the pump light that passes through the gas 732 onto the Q-switched crystal 728. The figure illustrates that the plasma sustaining region 722 and the plasma breakdown region 730 overlap in this perspective view. However, the angles and/or planes of incidence and beam shapes of the CW light 704 and the pulsed light 706 can be adjusted so that the regions 730, 722 do not overlap or only partially overlap in a three-dimensional region in the gas. High brightness light 734 emerges from the CW plasma that is sustained by the CW sustaining light 704.

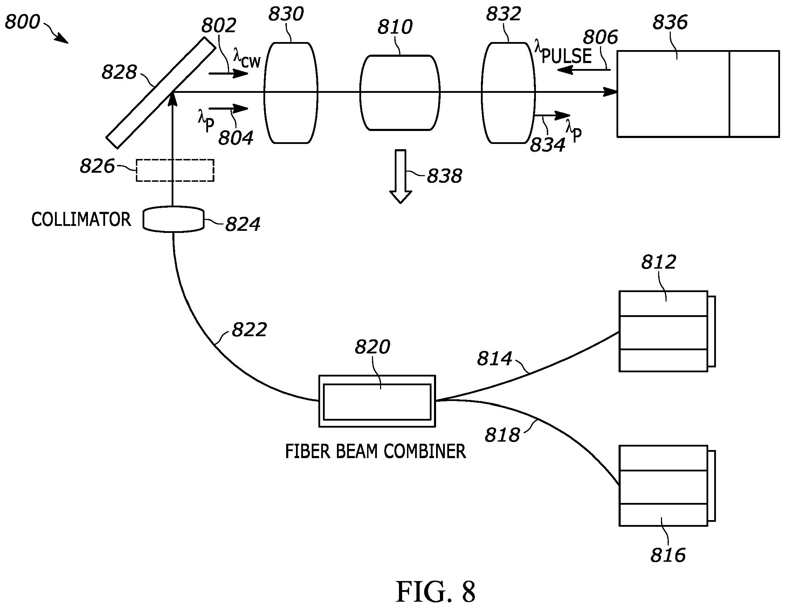

FIG. 8 illustrates an embodiment of an electrodeless laser-driven light source 800 where the CW laser light 802 and the pump light 804 are combined in a fiber combiner 820 and the pump light 804, the CW laser light 802, and the pulse light 806 are projected into a gas-filled bulb 810 along a same plane according to the present teaching. A pump laser 812 has a fiber optic output 814. In some embodiments, the pump laser 812 is a fiber laser. In some embodiments, the pump laser 812 is a fiber-coupled diode, or other solid-state, laser. A CW laser 816 has a fiber optic output 818. In some embodiments, the CW laser 816 is a fiber laser. In some embodiments, the CW laser 816 is a fiber-coupled diode, or other solid-state, laser. In some embodiments the CW laser 816 is a pulsed laser having sufficiently high pulse rate so as to have quasi-continuous output light.

The light from the fibers 814, 818 at the output of the pump laser 812 and CW laser 816 are combined in a fiber beam combiner 820. In some embodiments, the fiber beam combiner 822 is a fused fiber combiner. The fiber output 822 of the fiber beam combiner 820 provides the combined CW laser light 802 and the pump light 804 and the combined light is collimated in a collimator 824. In some embodiments, the collimator 824 collimates light at nominally 980 nm wavelength from a ~100-micron fiber core to form a ~8-10 mm collimated beam. In some embodiments, the collimator 824 collimates light at nominally 808 nm wavelength from a ~100-micron fiber core to form a ~2-3 mm collimated beam. In some embodiments, the collimator 824 is a gradient index (GRIN) lens. An optional filter 826 can be used to prevent the pulse light 806 from entering either or both of the pump laser 812 or the CW laser 816.

An optional directing element 828, such as a mirror and a focusing element 830 are used to direct and/or focus the CW light 802 and the pump light into the gas-filled bulb 810. A focusing element 832 is used to direct and/or collimate the pump light 804 that passes through the gas-filled bulb 810, the through pump light 834, to a Q-switched crystal 836. The through pump light 806 causes the Q-switched crystal 836 to generate the pulsed light 806. The collimating element 832 projects the pulsed light 806 into the gas-filled bulb 810.

A break-down region is formed in the gas-filled bulb 810 where the pulse light 806 energy generates a breakdown of the gas. A sufficient density of ions and electrons from the break-down region in the bulb 810 absorb the CW light 802 in the bulb and seed a CW plasma. The CW plasma emits high brightness light 838 that is sustained by the CW light 802. The generation of the plasma in the bulb causes a reduction in the power of the through pump light 806. This extinguishes the generation of pulse light 806 from the Q-switch crystal 836.

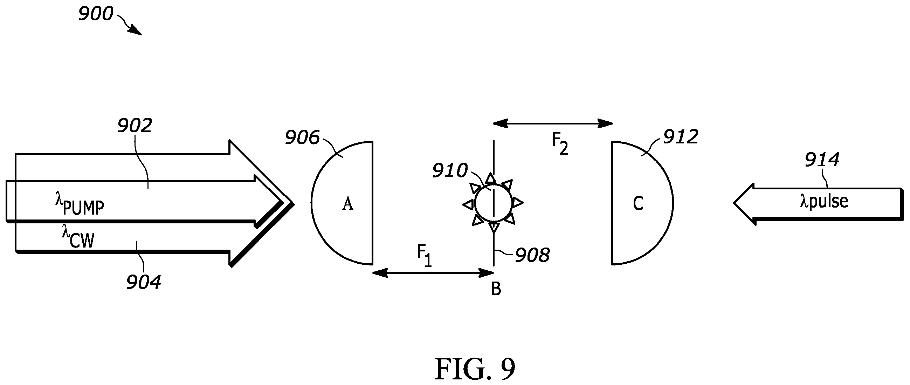

One feature of the present teaching is that it is possible to support colinear propagation of all of the pump, CW and pulsed light beams and to have the focal position of the multiple wavelengths of these beams arranged to overlap at a plane. FIG. 9 illustrates a detail-view of the excitation region in an embodiment of an electrodeless laser-driven light source 900 with co-linear laser excitation according to the present teaching. The pump beam 902 and the CW light beam 904 are incident on a lens 906. In some embodiments, the pump beam 902 wavelength is 808 nm. In some embodiments, the CW laser light beam 904 is 980 nm wavelength. In some embodiments, the lens 906 is an aspheric lens. In some embodiments, the lens 906 is a nominally 0.5-inch aperture, f=10 mm (wavelength dependent), NA=0.55 lens. The lens 904 focuses the incoming optical beam at the CW light wavelength at the focal plane 908, B. The plasma sustaining region 910 is also located in this plane 908. A second lens 912 is positioned at a distance from the plane 908, B that is equal to a focal length of the lens 912 at a wavelength of the pulse light 914. In some embodiments, the pulsed light 914 wavelength is 1064 nm. Thus, even if the same lens element model is used for the lenses 906, 912, the position of the first lens 906 from the plane 908, B, and the position of the second lens 912 from the plane 908, B are different, because the focal length of the lenses 906, 912 are a function of wavelength. In some embodiments a width of the CW light beam 904 is larger than a width of the pump beam 902 that is larger than a width of the pulse light beam 914. Thus, the focused spot size of the CW light beam 904 is smaller than a spot size of the pump beam 902 that is smaller than a spot size of the pulse light beam 914 at the focal plane 908, B. In some embodiments a width of the CW light beam 904 is nominally 9 mm, a width of the pump beam 902 is nominally 3 mm and a width of the pulse light beam 914 is nominally 1 mm. In various embodiments, the spot size and/or beam width of the pulse light beam 914 is adjusted, based on the desired energy density required in the plasma breakdown region.

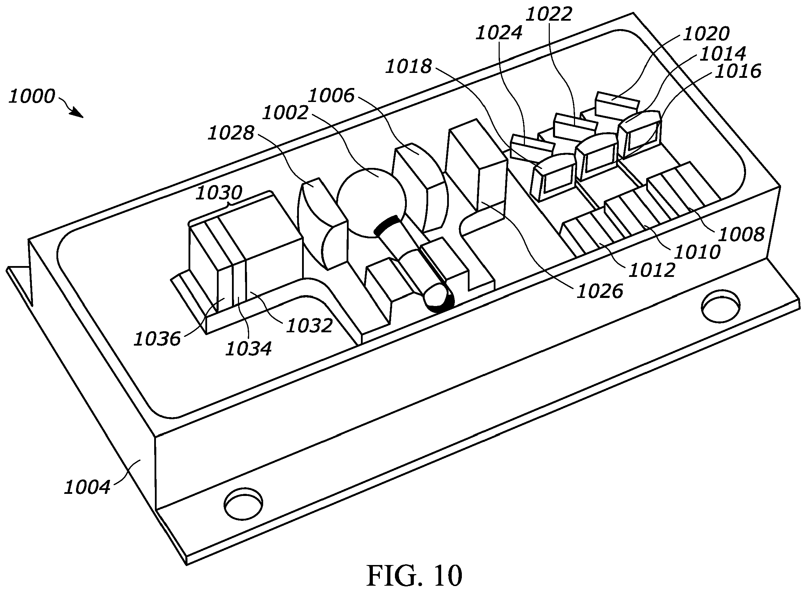

One feature of the all-optical electrodeless laser driven source of the present teaching is that it can be configured to fit in a single optical package. FIG. 10 illustrates an embodiment of a packaged electrodeless laser-driven light source 1000 with co-linear laser excitation according to the present teaching. A high-pressure electrodeless Xenon gas-filled bulb 1002 is positioned in a package 1004. A focusing lenses 1006 is used to focus pump light generated by a pump laser diode 1008 and CW light generated by laser diodes 1010, 1012. The light from the laser diodes 1008, 1010, 1012 is collimated with collimating optics 1014, 1016, 1018. The pump light is directed by a mirror 1020, and the CW light is combined and made collinear with the pump beam path by dichroic elements 1022, 1024. A filter 1026 passes the pump light and the CW light, but blocks the pulse light. A focusing lens 1028 focuses pulses generated in a Q-switched crystal 1030 to a breakdown region in the Xenon gas-filled bulb 1002. The Q-switched crystal includes a Yb:YAG rod section and a Cr:YAG or V:YAG saturable absorber section 1034. A high-reflective coating 1036 is applied to the end of the crystal 1030.

While the Applicant's teaching is described in conjunction with various embodiments, it is not intended that the Applicant's teaching be limited to such embodiments. On the contrary, the Applicant's teaching encompasses various alternatives and modifications, as will be appreciated by those of skill in the art, which may be made therein without departing from scope of the invention defined by the appended claims.

## Claims

1. An electrodeless laser-driven light source comprising:
a) a sustaining laser source that generates a continuous wave, CW, sustaining light at an
output;
b) a pump laser that generates a pump light at an output;
c) an optical beam combiner having a first input that is optically coupled to the output of the sustaining laser source and a second input that is optically coupled to the output of the pump laser, the optical beam combiner combining the CW sustaining light and the pump light at an output such that the CW sustaining light and the pump light propagate colinearly;
d) a Q-switched laser crystal having a pump input optically coupled to the output of the pump laser and configured such that the Q-switched laser crystal generates pulsed light at an output in response to the pump light; and
e) a gas-filled bulb optically coupled to the output of the sustaining laser and optically coupled to the output of the Q-switched laser crystal such that the pulsed light ignites a pulse plasma in a breakdown region of the gas bulb and the sustaining light sustains a CW plasma in a CW plasma region of the gas bulb, thereby emitting a high brightness light from the gas bulb, wherein
the gas-filled bulb is positioned between the output of the pump laser and the pump input of the Q-switched laser crystal such that the CW plasma absorbs the pump light, thereby quenching the pulsed light generated by the Q-switched laser crystal.

2. The electrodeless laser-driven light source of claim 1 wherein the sustaining laser source and the pump laser comprise a same laser, and/or are configured in one laser housing.

3. The electrodeless laser-driven light source of claim 1 or 2 wherein the optical combiner comprises a dichroic beam splitter or a fiber coupler.

4. The electrodeless laser-driven light source of any one of claims 1 to 3 wherein the Q-switched laser crystal comprises a gain section and a saturable absorber section.

5. The electrodeless laser-driven light source of any one of claims 1 to 4 wherein the Q-switched laser crystal comprises at least one of a glass host, an yttrium aluminum garnet host, and a spinel host, and/or at least one of a chromium dopant, a cobalt dopant, and a vanadium dopant.

6. The electrodeless laser-driven light source of any one of claims 1 to 5 wherein the Q-switched laser crystal comprises a narrow-band filter.

7. The electrodeless laser-driven light source of claim 6 wherein the narrow-band filter reflects at least some of the plasma light and/or the narrow-band filter blocks wavelengths in the Xenon spectrum.

8. The electrodeless laser-driven light source of any one of claims 1 to 7 wherein a pressure in the gas-filled bulb is in a range of 20 atm. to 50 atm.

9. A method of igniting an electrodeless laser-driven light source, the method comprising:
a) providing electromagnetic energy to a gas within a gas-filled bulb using a continuous CW laser light;
b) providing laser pump radiation to a Q-switched laser crystal, thereby generating laser pulses;
c) providing the laser pulses to the gas within the gas-filled bulb to generate a pulse plasma in a breakdown region in the gas;
d) producing a CW plasma that emits a high-brightness light in a CW plasma region using the provided electromagnetic energy to the ionized gas and the pulse plasma; and
e) passing the laser pump radiation that is provided to the Q-switched laser crystal through the CW plasma region such that the CW plasma absorbs the pump light, thereby quenching the pulsed light generated by the Q-switched laser crystal.

10. The method of igniting the electrodeless laser-driven light source of claim 9 wherein the providing electromagnetic energy to a gas within a gas-filled bulb and the providing laser pump radiation to a Q-switched laser crystal comprise using a same laser to provide the electromagnetic energy and the pump radiation.

11. The method of igniting the electrodeless laser-driven light source of claim 9 or 10 wherein the breakdown region and the CW plasma region overlap or do not overlap.

12. The method of igniting the electrodeless laser-driven light source of any one of claims 9 to 11 wherein a pulse repetition rate of the laser pulses is in a range less than or equal to 1kHz or in a range of 1kHz to 20kHz.

13. The method of igniting the electrodeless laser-driven light source of any one of claims 9 to 12 wherein a pulse energy of the laser pulses is in a range of 350 *µ*Joules to 50 mJoules.

14. The method of igniting the electrodeless laser-driven light source of any one of claims 9 to 13 wherein a pulse duration of the laser pulses is in a range of 0.1 ns to 10 ns.

15. The method of igniting the electrodeless laser-driven light source of any one of claims 9 to 14 wherein a power of the continuous CW laser light is in a range of 5W to 1500 W.

## Patentansprüche

1. Elektrodenlose, lasergetriebene Lichtquelle, umfassend:
a) eine Erhaltungslaserquelle, die ein kontinuierliches, CW, Erhaltungslicht an einem Ausgang erzeugt;
b) einen Pumplaser, der ein Pumplicht an einem Ausgang erzeugt;
c) einen optischen Strahlkombinierer mit einem ersten Eingang, der optisch mit dem Ausgang der Erhaltungslaserquelle gekoppelt ist, und einem zweiten Eingang, der optisch mit dem Ausgang des Pumplasers gekoppelt ist, wobei der optische Strahlkombinierer das CW-Erhaltungslicht und das Pumplicht an einem Ausgang so kombiniert, dass sich das CW-Erhaltungslicht und das Pumplicht kollinear ausbreiten;
d) einen gütegeschalteten Laserkristall mit einem Pumpeingang, der optisch mit dem Ausgang des Pumplasers gekoppelt und so konfiguriert ist, dass der gütegeschaltete Laserkristall in Reaktion auf das Pumplicht gepulstes Licht an einem Ausgang erzeugt; sowie
e) einen gasgefüllten Kolben, der optisch mit dem Ausgang des Erhaltungslasers gekoppelt ist und optisch mit dem Ausgang des gütegeschalteten Laserkristalls gekoppelt ist, so dass das gepulste Licht ein Impulsplasma in einem Durchbruchbereich des Gaskolbens zündet und das Erhaltungslicht ein CW-Plasma in einem CW-Plasmabereich des Gaskolbens aufrechterhält, wodurch ein Licht von hoher Helligkeit aus dem Gaskolben emittiert wird, wobei
der gasgefüllte Kolben zwischen dem Ausgang des Pumplasers und dem Pumpeingang des gütegeschalteten Laserkristalls so positioniert ist, dass das CW-Plasma das Pumplicht absorbiert, wodurch das von dem gütegeschalteten Laserkristall erzeugte gepulste Licht gelöscht wird.

2. Elektrodenlose lasergetriebene Lichtquelle nach Anspruch 1, wobei die Erhaltungslaserquelle und der Pumplaser den selben Laser umfassen und/oder in einem einzelnen Lasergehäuse angeordnet sind.

3. Elektrodenlose lasergetriebene Lichtquelle nach Anspruch 1 oder 2, wobei der optische Strahlkombinierer einen dichroitischen Strahlteiler oder einen Faserkoppler umfasst.

4. Elektrodenlose lasergetriebene Lichtquelle nach einem der Ansprüche 1 bis 3, wobei der gütegeschaltete Laserkristall einen Verstärkungsabschnitt und einen sättigbaren Absorberabschnitt umfasst.

5. Elektrodenlose lasergetriebene Lichtquelle nach einem der Ansprüche 1 bis 4, wobei der gütegeschaltete Laserkristall wenigstens eines von einem Glas-Wirtsmaterial, einem Yttrium-Aluminium-Granat-Wirtsmaterial und einem Spinell-Wirtsmaterial und/oder wenigstens einen von einem Chrom-Dotierstoff, einem Kobalt-Dotierstoff und einem Vanadium-Dotierstoff umfasst.

6. Elektrodenlose lasergetriebene Lichtquelle nach einem der Ansprüche 1 bis 5, wobei der gütegeschaltete Laserkristall ein Schmalbandfilter umfasst.

7. Elektrodenlose lasergetriebene Lichtquelle nach Anspruch 6, wobei das Schmalbandfilter wenigstens einen Teil des Plasmalichts reflektiert und/oder das Schmalbandfilter Wellenlängen in dem Xenon-Spektrum blockiert.

8. Elektrodenlose lasergetriebene Lichtquelle nach einem der Ansprüche 1 bis 7, wobei ein Druck in dem gasgefüllten Kolben in einem Bereich von 20 atm bis 50 atm liegt.

9. Verfahren zum Zünden einer elektrodenlosen lasergetriebenen Lichtquelle, wobei das Verfahren umfasst:
a) Bereitstellen elektromagnetischer Energie für ein Gas im Inneren eines gasgefüllten Kolbens unter Verwendung eines kontinuierlichen CW-Laserlichts;
b) Bereitstellen von Laserpumpstrahlung für einen gütegeschalteten Laserkristall, wodurch Laserpulse erzeugt werden;
c) Bereitstellen der Laserpulse für das Gas im Inneren des gasgefüllten Kolbens, um ein Pulsplasma in einem Durchbruchsbereich in dem Gas zu erzeugen;
d) Erzeugen eines CW-Plasmas, das ein Licht hoher Helligkeit in einem CW-Plasmabereich emittiert, unter Verwendung der bereitgestellten elektromagnetischen Energie für das ionisierte Gas und des Pulsplasmas; und
e) Hindurchleiten der Laserpumpstrahlung, die für den gütegeschalteten Laserkristall bereitgestellt wird, durch den CW-Plasmabereich, so dass das CW-Plasma das Pumplicht absorbiert, wodurch das durch den gütegeschalteten Laserkristall erzeugte gepulste Licht gelöscht wird.

10. Verfahren zum Zünden der elektrodenlosen lasergetriebenen Lichtquelle nach Anspruch 9, wobei das Bereitstellen elektromagnetischer Energie für ein Gas im Inneren eines gasgefüllten Kolbens und das Bereitstellen von Laserpumpstrahlung für einen gütegeschalteten Laserkristall Einsatz ein und desselben Lasers zum Bereitstellen der elektromagnetischen Energie und der Pumpstrahlung umfasst.

11. Verfahren zum Zünden der elektrodenlosen lasergetriebenen Lichtquelle nach Anspruch 9 oder 10, wobei sich der Durchbruchsbereich und der CW-Plasmabereich überlappen oder nicht überlappen.

12. Verfahren zum Zünden der elektrodenlosen lasergetriebenen Lichtquelle nach einem der Ansprüche 9 bis 11, wobei eine Pulswiederholrate der Laserpulse in einem Bereich kleiner oder gleich 1 kHz oder in einem Bereich von 1 kHz bis 20 kHz liegt.

13. Verfahren zum Zünden der elektrodenlosen lasergetriebenen Lichtquelle nach einem der Ansprüche 9 bis 12, wobei eine Pulsenergie der Laserpulse in einem Bereich von 350 µJ bis 50 mJ liegt.

14. Verfahren zum Zünden der elektrodenlosen lasergetriebenen Lichtquelle nach einem der Ansprüche 9 bis 13, wobei eine Pulsdauer der Laserpulse in einem Bereich von 0,1 ns bis 10 ns liegt.

15. Verfahren zum Zünden der elektrodenlosen lasergetriebenen Lichtquelle nach einem der Ansprüche 9 bis 14, wobei eine Leistung des kontinuierlichen CW-Laserlichts in einem Bereich von 5 W bis 1500 W liegt

## Revendications

1. Source lumineuse commandée par laser sans électrode comprenant :
a) une source laser d'entretien qui génère une lumière d'entretien à onde continue, CW, en sortie ;
b) un laser de pompage qui génère une lumière de pompage en sortie ;
c) un combineur de faisceaux optiques ayant une première entrée qui est couplée optiquement à la sortie de la source laser d'entretien et une seconde entrée qui est couplée optiquement à la sortie du laser de pompage, le combineur de faisceaux optiques combinant la lumière d'entretien CW et la lumière de pompage en sortie de sorte que la lumière d'entretien CW et la lumière de pompage se propagent de façon colinéaire ;
d) un cristal laser à commutation Q ayant une entrée de pompage couplée optiquement à la sortie du laser de pompage et configuré de sorte que le cristal laser à commutation Q génère une lumière pulsée en sortie en réponse à la lumière de pompage ; et
e) une ampoule remplie de gaz couplée optiquement à la sortie du laser d'entretien et couplée optiquement à la sortie du cristal laser à commutation Q, de sorte que la lumière pulsée allume un plasma pulsé dans une région de claquage de l'ampoule de gaz et que la lumière d'entretien entretienne un plasma CW dans une région de plasma CW de l'ampoule de gaz, émettant ainsi une lumière de haute brillance à partir de l'ampoule de gaz, dans laquelle
l'ampoule remplie de gaz est positionnée entre la sortie du laser de pompage et l'entrée de pompage du cristal laser à commutation Q, de sorte que le plasma CW absorbe la lumière de pompage, ce qui interrompt la lumière pulsée générée par le cristal laser à commutation Q.

2. Source lumineuse commandée par laser sans électrode selon la revendication 1, dans laquelle la source laser d'entretien et le laser de pompage comprennent le même laser et/ou sont configurés dans un même boîtier laser.

3. Source lumineuse commandée par laser sans électrode selon la revendication 1 ou 2, dans laquelle le combineur optique comprend un séparateur de faisceau dichroïque ou un coupleur de fibres.

4. Source lumineuse commandée par laser sans électrode selon l'une quelconque des revendications 1 à 3, dans laquelle le cristal laser à commutation Q comprend une section de gain et une section d'absorption saturable.

5. Source lumineuse commandée par laser sans électrode selon l'une quelconque des revendications 1 à 4, dans laquelle le cristal laser à commutation Q comprend au moins l'un parmi un hôte en verre, un hôte en grenat d'yttrium-aluminium et un hôte en spinelle, et/ou au moins l'un parmi un dopant au chrome, un dopant au cobalt et un dopant au vanadium.

6. Source lumineuse commandée par laser sans électrode selon l'une quelconque des revendications 1 à 5, dans laquelle le cristal laser à commutation Q comprend un filtre à bande étroite.

7. Source lumineuse commandée par laser sans électrode selon la revendication 6, dans laquelle le filtre à bande étroite réfléchit au moins une partie de la lumière plasma et/ou le filtre à bande étroite bloque les longueurs d'onde dans le spectre du xénon.

8. Source lumineuse commandée par laser sans électrode selon l'une quelconque des revendications 1 à 7, dans laquelle la pression dans l'ampoule remplie de gaz se trouve dans la plage allant de 20 atm à 50 atm.

9. Procédé d'allumage d'une source lumineuse commandée par laser sans électrode, le procédé comprenant :
a) la fourniture de l'énergie électromagnétique à un gaz dans une ampoule remplie de gaz en utilisant une lumière laser CW ;
b) la fourniture d'un rayonnement de pompage laser à un cristal laser à commutation Q, générant ainsi des impulsions laser ;
c) la fourniture des impulsions laser au gaz dans l'ampoule remplie de gaz pour générer un plasma pulsé dans une région de claquage dans le gaz ;
d) la production d'un plasma CW qui émet une lumière de haute brillance dans une région de plasma CW en utilisant l'énergie électromagnétique fournie au gaz ionisé et au plasma pulsé ; et
e) le passage du rayonnement de pompage laser qui est fourni au cristal laser à commutation Q à travers la région de plasma CW de sorte que le plasma CW absorbe la lumière de pompage, ce qui interrompt la lumière pulsée générée par le cristal laser à commutation Q.

10. Procédé d'allumage de la source lumineuse commandée par laser sans électrode selon la revendication 9, dans lequel la fourniture de l'énergie électromagnétique à un gaz dans une ampoule remplie de gaz et la fourniture d'un rayonnement de pompage laser à un cristal laser à commutation Q comprennent l'utilisation d'un même laser pour fournir l'énergie électromagnétique et le rayonnement de pompage.

11. Procédé d'allumage de la source lumineuse commandée par laser sans électrode selon la revendication 9 ou 10, dans lequel la région de claquage et la région de plasma CW se chevauchent ou ne se chevauchent pas.

12. Procédé d'allumage de la source lumineuse commandée par laser sans électrode selon l'une quelconque des revendications 9 à 11, dans lequel la fréquence de répétition d'impulsion des impulsions laser est inférieure ou égale à 1 kHz ou se trouve dans la plage allant de 1 kHz à 20 kHz.

13. Procédé d'allumage de la source lumineuse commandée par laser sans électrode selon l'une quelconque des revendications 9 à 12, dans lequel l'énergie d'impulsion des impulsions laser se trouve dans la plage allant de 350 µJ à 50 mJ.

14. Procédé d'allumage de la source lumineuse commandée par laser sans électrode selon l'une quelconque des revendications 9 à 13, dans lequel la durée d'impulsion des impulsions laser se trouve dans la plage allant de 0,1 ns à 10 ns.

15. Procédé d'allumage de la source lumineuse commandée par laser sans électrode selon l'une quelconque des revendications 9 à 14, dans lequel la puissance de la lumière laser CW continue se trouve dans la plage allant de 5 W à 1500 W.
